(19) Europäisches Patentamt
European Patent Office
Office européen des brevets

(11) EP 0 394 740 B1

(12) EUROPÄISCHE PATENTSCHRIFT

(45) Veröffentlichungstag und Bekanntmachung des Hinweises auf die Patenterteilung:
**13.11.1996 Patentblatt 1996/46**

(51) Int Cl.$^6$: **G03F 7/38**

(21) Anmeldenummer: **90106831.2**

(22) Anmeldetag: **10.04.1990**

# (54) Trockenentwickelbares Resistsystem

Dry development resist system

Système formant réserve pour le développement à sec

(84) Benannte Vertragsstaaten:
**BE CH DE ES FR GB IT LI NL SE**

(30) Priorität: **24.04.1989 DE 3913434**

(43) Veröffentlichungstag der Anmeldung:
**31.10.1990 Patentblatt 1990/44**

(73) Patentinhaber: **SIEMENS AKTIENGESELLSCHAFT**
**80333 München (DE)**

(72) Erfinder:
- **Sezi, Recai, Dr.-Ing.**
  **D-8551 Röttenbach (DE)**
- **Leuschner, Rainer, Dr. rer. nat.**
  **D-8521 Grossenseebach (DE)**
- **Sebald, Michael, Dr. rer. nat.**
  **D-8521 Hessdorf (DE)**
- **Birkle, Siegfried, Dr. rer. nat.**
  **D-8552 Höchstadt (DE)**
- **Ahne, Hellmut, Dr.**
  **D-8551 Röttenbach (DE)**

(56) Entgegenhaltungen:
**EP-A- 0 136 130** **EP-A- 0 249 769**
**US-A- 4 613 398**

- **IBM TECHNICAL DISCLOSURE BULLETIN, vol. 23, no. 5, Oktober 1980, New York US, Seite 1839; C.J. HAMEL et al.: 'Negative-Acting Positive Photoresist'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 394 740 B1

Printed by Jouve, 75001 PARIS (FR)

## Beschreibung

Die Erfindung betrifft ein fein strukturierbares Resistsystem für ein Trockenentwicklungsverfahren, bei dem in einer lichtempfindlichen Photoresistschicht durch abbildende Belichtung ein latentes Bild erzeugt und durch Behandlung mit einem Agens eine spezifische chemische Veränderung zur Erhöhung der Ätzresistenz gegenüber einem Trockenätzverfahren erzielt wird, sowie ein Strukturierungsverfahren mit Trockenentwicklung.

Photoresists finden vor allem in der mikroelektronischen Industrie, zum Beispiel bei der Herstellung von Halbleiterbauelementen, Verwendung. Beispielsweise zur Erzeugung von integrierten Schaltkreisen oder Speicherbausteinen sind sie unabdingbar. Sie dienen zur Definition und Erzeugung von Strukturen auf photolithographischem Weg, wobei eine vorgegebene Struktur von einer Vorlage (Maske) mittels optischer Methoden auf ein Substrat, zum Beispiel einen Wafer, übertragen wird. Die Übertragung gelingt mit einer Hilfsschicht aus Photoresist, in der durch die Belichtung eine gezielte chemische Veränderung vorgenommen wird. Durch das unterschiedliche chemische Verhalten von belichteten und unbelichteten Bereichen ist eine Entwicklung dieses "Bildes" möglich, welche auf naßchemischem oder auch trockenem Weg vorgenommen werden kann.

Die fortschreitende Entwicklung in der Mikroelektronik bringt eine Zunahme der Integrationsdichte mit sich. Bei immer kleiner werdenden Strukturen werden auch an die Strukturerzeugung höhere Ansprüche gestellt. Es müssen immer kleinere Strukturen erzeugt werden, wodurch eine höhere Auflösung und ein höherer Kontrast der verwendeten Photoresistsysteme erforderlich ist.

Um diese Ansprüche zu erfüllen, sind weitere Verbesserungen der Resistsysteme, der Technologie, der Geräte und der Verfahren notwendig. Großen Einfluß auf die Qualität der Strukturübertragung haben auch einige Eigenschaften der zur Belichtung verwendeten Stepper bzw. der Stepperlinse. Diese stehen mit der Wellenlänge $\lambda$ in einem gesetzmäßigen Zusammenhang, welcher der maximal erzielbaren Auflösung eine physikalische Grenze setzt. Gemäß den Gleichungen

$$CD = k_1 \frac{\lambda}{NA} \; ; \; DOT = k_2 \frac{\lambda}{(NA)^2}$$

ist die kleinste aufgelöste Strukturgröße (critical dimension = CD) sowie die Tiefenschärfe (depth of focus = DOF) proportional zur Wellenlänge des verwendeten Lichts und indirekt proporitonal zum Quadrat der numerischen Apertur (NA) der verwendeten Linse. Weitere Verbesserungen in der Strukturauflösung können also durch Reduzierung der Belichtungswellenlänge erzielt werden.

Naß entwickelbare Einlagenresists bestehen zum Beispiel aus einem Basispolymeren und einer photoaktiven Komponente. Bekannte Systeme enthalten zum Beispiel Novolakharze als Basispolymer und Chinonazide als photoaktive Komponente. Solche Systeme genügten lange Zeit den Anforderungen der Photolithographie, können jedoch die zukünftigen Anforderungen, zum Beispiel Strukturierung mit Excimerlasersteppern im tiefen UV (deep UV = DUV) Bereich zur Erzeugung von Resiststrukturen unterhalb 0,5 µm mit senkrechten Flanken bei hoher Resistdicke nicht mehr erfüllen. Insbesondere auch bei immer stufiger werdender Substrattopographie oder über hochreflektierenden Unterlagen werden mit den bekannten Systemen unzureichende Auflösungen erzielt. Da mit kürzerer Belichtungswellenlänge und hoher numerischer Apertur zur Erzeugung sehr kleiner Strukturen die Tiefenschärfe ebenfalls kleiner wird, ist es bei den naßentwickelbaren Einlagenresists sehr schwierig, bei relativ dicken Resistschichten und unvermeidbaren Schichtdickenschwankungen (über Stufen auf einem Substrat) eine hohe Auflösung zu erzielen. Auch wegen der hohen Eigenabsorption der Novolake sind diese Systeme für eine DUV-Strukturierung (zum Beispiel bei 248 nm) ungeeignet.

Zur Eliminierung der obengenannten Probleme bei Verwendung von naßentwickelbaren Einlagenresists sind neuere jedoch kompliziertere Zweilagensysteme entwickelt worden. Bei diesen wird nur noch eine obere dünne Schicht belichtet und strukturiert, und die so erzeugte Struktur schließlich in die untere Schicht bzw. in die unteren Schichten übertragen, wobei die zuerst strukturierte Schicht als Kontaktmaske dient. Je nach System wird dazu eine Naßentwicklung, eine Trockenentwicklung ($O_2$/RIE) oder eine Kombination beider Verfahren herangezogen.

Trockenentwickelbare Einlagensysteme besitzen meist eine geringere Komplexität als Zweilagensysteme, weisen aber teilweise deren Vorteile auf. Bei diesem Prinzip wird zunächst in einer Resistschicht ein latentes Bild durch Belichtung erzeugt und anschließend durch spezifische chemische Behandlung ausschließlich in belichteten bzw. unbelichteten Bereichen chemisch verändert. Durch Behandlung mit einer organischen Metallverbindung, zum Beispiel einer Organosiliziumverbindung, kann so eine Ätzresistenz, zum Beispiel gegenüber einem Sauerstoffplasma bei der Trockenentwicklung erzeugt werden. Der "Zweilageneffekt" wird dadurch erzielt, daß die chemische Veränderung nur in oberflächennahen Bereichen erfolgt und die Struktur erst mittels anisotroper Entwicklung auf die darunterliegenden Bereiche übertragen wird.

Ein solches Verfahren wird zum Beispiel in der US-PS 4 552 833 beschrieben. Eine Resistschicht, bestehend aus

t-Butoxycarbonyloxystyrol und einer photoaktiven Komponente, wird mit UV-Licht strukturierend belichtet und anschließend in einem Vakuumofen mit gasförmigem Hexamethyldisilazan bei 85°C behandelt. Durch die dabei erfolgte Silylierung der belichteten Bereiche der Resistoberfläche wird durch anschließende "Entwicklung" im Sauerstoffplasma hochaufgelöste Strukturen erhalten.

Ein weiterer Vertreter dieser Einlagenresistsysteme wird in der europäischen Patentanmeldung EP-A 0 13 61 30 beschrieben, bei der nach der Belichtung eines Resists auf Acrylatbasis durch Elektronenstrahlen, Behandlung mit Diborangas bei 40°C und anschließender Trockenentwicklung eine Auflösung von 0,5 µm erhalten wird.

Aus der US-A-4613398 ist ein Resistsystem bekannt, welches nach der Belichtung mit einem metallorganischen Agens umgesetzt wird, µm in den umgesetzten Bereichen eine Ätzresistenz zu erzeugen. Für das metallorganische Agens wird beispielsweise Hexamethyldisilazan vorgeschlagen.

Eine Silylierung mit Hexamethyldisilazan oder Chlorsilanen wird in den Patentanmeldungen EP-A 0184567 und EP-A 0248779 beschrieben.

Ähnliche Resultate werden mit kommerziellen Resists und Siliziumtetrachlorid als Behandlungsreagenz erhalten.

Allen diesen Beispielen für trockenentwickelbare Einlagenresists haften jedoch verschiedene Nachteile an: so werden in allen Verfahren feuchteempfindliche, korrosive oder giftige Gase bzw. Flüssigkeiten eingesetzt, es werden spezielle evakuierbare Apparaturen benötigt, die Verfahren erfordern lange Prozeßzeiten, die Behandlung muß bei erhöhter Temperatur durchgeführt werden und die Prozeßführung und Reproduzierbarkeit ist wegen mehrerer Prozeßparameter kritisch.

Aufgabe der vorliegenden Erfindung ist es daher, ein trockenentwickelbares Resistsystem anzugeben, welches eine einfache Handhabung erlaubt, mit vorhandenen üblichen Apparaturen durchzuführen ist, welches eine hohe Selektivität im Sauerstoffplasma aufweist und zu hochaufgelösten Strukturen mit steilen Flanken führt.

Diese Aufgabe wird durch ein Resistsystem nach Anspruch 1 gelöst.

Weitere Ausgestaltungen der Erfindung sowie ein Verfahren zum Herstellen einer Resiststruktur mit steilen Flanken sind den Unteransprüchen zu entnehmen.

Das erfindungsgemäße Resistsystem ist einfach handhabbar, da es nur aus zwei Komponenten besteht und im Einsatz für ein Lithographieverfahren gegenüber einem normalen Einlagenresist nur einen weiteren Verfahrensschritt benötigt. Die Anwendungen des Systems sind vielfältig, da es an die verschiedensten Parameter angepaßt werden kann. Die Empfindlichkeit bezüglich Intensität und Wellenlänge der zur Belichtung verwendeten Strahlung sind Eigenschaften des Photoresists und können unabhängig von weiteren Parametern optimiert werden, während die Ätzresistenz und weitere thermisch mechanische Eigenschaften des Resistsystems bzw. einer daraus erzeugten Photoresiststruktur durch die Behandlung mit der Komponente B induziert werden. Nicht unabhängig wählbar sind lediglich die funktionellen Gruppen der Komponente A bzw. der Komponente B, da eine chemische Verbindungsbildung zwischen den beiden Komponenten möglich sein muß. Die dabei durch spezifische Reaktion an der Resistschicht angebundene organische Metallverbindung erzeugt in dieser eine erhöhte Ätzresistenz gegenüber einem Sauerstoffplasma. Da die Reaktion spezifisch in belichteten bzw. nicht belichteten Bereichen der Photoresistschicht abläuft, wird das nach der Belichtung bislang nur latente Bild chemisch verändert und erhält so gewissermaßen einen besseren Kontrast. Daher können im Entwicklungsverfahren, einem anisotropen Ätzprozeß im Sauerstoffplasma, kontrastreiche und hochaufgelöste Strukturen mit steilen Flanken erzeugt werden.

Ein erfindungsgemäßer Photoresist besteht aus einem Basispolymeren und einer photoaktiven Komponente, wobei das Basispolymer eine Anhydrid- oder Epoxidgruppe als funktionelle Gruppe aufweist. Ein solcher Photoresist ist unter Normalbedingungen gut lagerbar und ermöglicht trotzdem aufgrund der funktionellen Gruppen die chemische Reaktion mit einer Vielzahl verschiedener Reagenzien. Mit geeigneten photoaktiven Komponenten kann ein solcher Photoresist auch im tiefen UV-Bereich (= DUV) belichtet und somit strukturiert werden, da die Basispolymeren mit den angegebenen funktionellen Gruppen eine hohe Transparenz für Strahlung im DUV-Bereich aufweisen. Gut ausbleichende photoaktive Komponenten sind zum Beispiel in der Klasse der Chinondiazide zu finden.

Als Komponente B wird vorzugsweise eine $\alpha$, $\Omega$ -bifunktionelle Organosiliziumverbindung mit 1-50 vorzugsweise zwei bis zwölf Siliziumatomen pro Molekül ausgewählt. Durch zwei oder auch mehr funktionelle Gruppen pro Molekül der Komponente B wird eine sichere Anbindung der Organosiliziumverbindung an spezifische Bereiche der Photoresistschicht gewährleistet. Je mehr Siliziumatome enthalten sind, um so schneller wächst die Ätzresistenz der behandelten Photoresistschicht. Je mehr Silizium in der Resistschicht enthalten ist, um so mehr nicht flüchtiges Siliziumdioxid kann im Sauerstoffplasma gebildet werden. Die Molekülgröße für die Organosiliziumverbindung ist nach oben hin begrenzt, da z.B. in einer Ausführungsform eine ausreichende Löslichkeit in in Wasser oder in zumindest Wasser enthaltendem Medium gegeben sein muß. Auch soll die Diffusion der Komponente B in die Photoresistschicht (Komponente A) nicht durch zu große Moleküle behindert werden. Die Diffusion der Organosiliziumverbindung in die Resistschicht hinein ist notwendig, um eine ausreichend dicke ätzresistente Schicht zu erzeugen. Das Silylierungsagens kann zum Beispiel ein Organosilan sein, welches als funktionelle Gruppe zumindest eine Aminogruppe aufweist. Solche Silane sind hydrolysestabil und in Lösung lange beständig. Die angegebenen reaktiven Gruppen erlauben eine gute Anbindung an die funktionellen Gruppen des Basispolymeren und erzeugen gleichzeitig eine gute Löslichkeit im

"wäßrigen" Medium.

Weitere Vorteile werden erzielt, wenn in der Komponente B ein Organosiloxan enthalten ist, welches die bereits angegebenen reaktiven Gruppen aufweist. In diesem sind bereits 51-0-Bindungen vorgebildet, die im Sauerstoffplasma eine leichtere und schnellere Erzeugung von Siliziumdioxid bewirken und die Wahrscheinlichkeit für intermediär auftretende flüchtige Organosiliziumverbindungen herabsetzen.

Gute Ergebnisse werden mit einem Photoresist erzielt, der im Basispolymer Anhydridgruppen aufweist. Diese können cyclisch oder linear sein, in der Hauptkette oder in einer Seitenkette des Basispolymeren enthalten sein oder gar die Funktion darstellen, mit der die Kettenglieder verknüpft sind. Solche Polymere weisen eine hohe DUV-Transparenz auf($\alpha_{248}$ etwa 0,1 $\mu m^{-1}$), da die Anhydridgruppe keine erhöhte Absorption für DUV zeigt, und besitzen eine hohe Erweichungstemperatur von größer 160°C. Diese ist besonders für die mit höheren Temperaturen verbundenen plasmaätzprozesse von Bedeutung, da so ein Verfließen der erzeugten Strukturen während des Ätzprozesses verhindert wird. Mit gängigen photoaktiven Komponenten wie zum Beispiel den bereits erwähnten Chinondiaziden kann mit dem Photoresist ein hoher Kontrast erzielt werden. Die durch die Belichtung hydrophil gewordenen Bereiche der Photoresistschicht begünstigen die Diffusion des z.B. im wäßrigen Medium vorliegenden Silylierungsagens in die Photoresistschicht, wo sie chemisch angebunden werden. In diesem Fall ist zumindest eine Aminofunktion am Silylierungsagens unbedingt erforderlich, da sonst die "Hydrolyse" derAnhydridgruppe zu langsam verläuft.

Es werden dabei Amidocarbonsäuren gebildet, die ihrerseits nun mit anderen funktionellen Gruppen zu reagieren vermögen. Vorzugsweise werden in diesem Fall Diamino-organosiliziumverbindungen eingesetzt, doch sind zum Beispiel auch aminoalkoholische Siliziumverbindungen möglich.

Ein erfindungsgemäßer Photoresist kann als Basispolymer ein Homo- oder Copolymer darstellen, das zu 1 bis 100 Prozent von Anhydridfunktionen tragenden Monomeren abgeleitet ist. Vorteilhaft und gut zugänglich ist ein Basispolymer, das zu 10 bis 55 Mol-Prozent aus Maleinsäureanhydridmonomeren abgeleitet ist. In diesem Fall und ebenso bei Verwendung anderer, Anhydridfunktionen tragender Monomerer können die weiteren Monomere von Copolymeren so ausgewählt sein, daß zum Beispiel die Ätzresistenz gegen ein halogenhaltiges Plasma verstärkt wird. Dies wird insbesondere durch aromatische Verbindungen erreicht.

Solche weiteren Monomere können beispielsweise den folgend dargestellten Strukturformeln A, B, C oder D gehorchen,

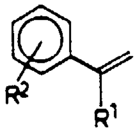
A

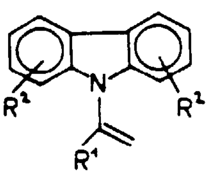
B

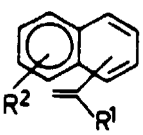
C

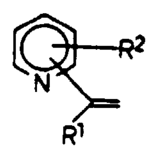
D

wobei $R^1$ und $R^2$ unabhängig voneinander für H, Alkyl, Aryl oder Halogen stehen.

Ein erfindungsgemäßer Photoresist kann daher zum Beispiel ein der allgemeinen Strukturformel E gehorchendes Basispolymer aufweisen,

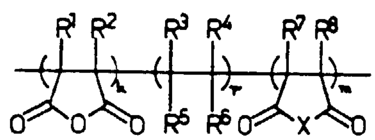

$$\left(O < \frac{k}{k+r+m} \leq 0,6\right)$$

E

wobei das Strukturfragment mit dem Index k in einem Anteil von 10 bis 60 Prozent der Strukturfragmente an der Gesamtstruktur beteiligt ist, k, r und m ganze Zahlen darstellen und r oder m den Wert O annehmen können, $R^3$ bis $R^{10}$ Wasserstoff, Alkyl, Aryl, Halogen, halogensubstituiertes Alkyl bzw. Aryl oder einen olefinisch ungesättigten Rest

bedeuten, $R^5$ außerdem Methoxyphenyl,

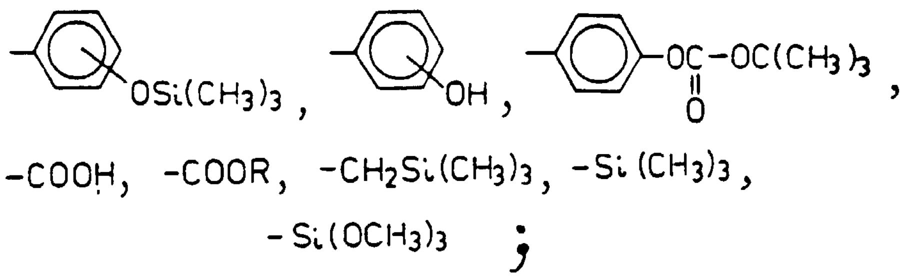

und X = O, NR oder S ist, und R gleich H, Alkyl, Aryl, Vinyl, Allyl oder Acryl. Als regelmäßig wiederkehrende Einheiten kann das Basispolymer außerdem den Strukturformeln F, G, H oder I gehorchende Fragmente in der Kette aufweisen, wobei $R^3$ und $R^4$ für die bereits angegebenen Gruppen stehen kann. Desweiteren kann das Basispolymer von Anhydridmonomeren abgeleitet sein, die zumindest einer der Strukturen K oder L gehorchen,

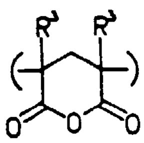 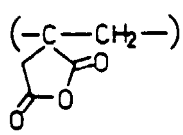 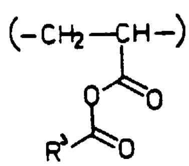 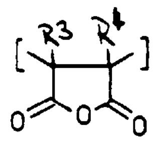

F G H I

K 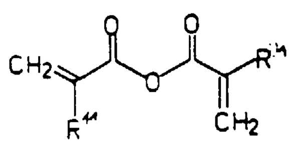 L 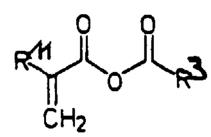

wobei $R^{11}$ und $R^{12}$ für H oder Alkyl stehen.

Gut geeignete photoaktive Komponenten können einer der Strukturformeln P, Q oder R gehorchen oder von einer dieser Strukturen abgeleitet sein,

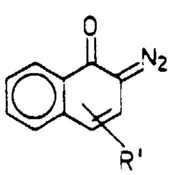 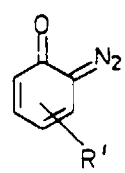 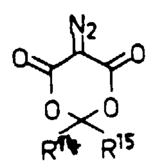

P Q R

wobei $R^{14}$ und $R^{15}$ unabhängig voneinander einen beliebigen organischen Rest bedeuten, R′ für $-SO_3R$ oder $-CO_2R$ steht, wobei R für Alkyl, Aryl, Halogenalkyl, Halogenaryl, Halogen oder Alkoxyaryl steht. Die effektiv eingesetzte PAC ist dabei mit ihren Resten R auf das Basispolymer abgestimmt. Eine für anhydridhaltige Photoresist gut geeignete photoaktive Komponente ist der 4-Sulfonsäureester von Naphthochinondiazid mit mehrwertigen Phenolen wie beispielsweise Bisphenol A.

Im erfindungsgemäßen Verfahren zum Herstellen einer Resiststruktur mit Hilfe des erfindungsgemäßen Resistsystems wird zunachst auf einem Substrat, dessen Oberfläche aus Halbleitermaterial, Metall, Keramik oder beliebig anderen zu strukturierenden Materialien besteht, eine Photoresistschicht (Komponente A) in bekannter Weise erzeugt. Unter Zuhilfenahme einer Maske wird die Photoresistschicht bildmäßig belichtet, wobei durch photochemische Reaktion in den belichteten Bereichen der Photoresistschicht ein latentes Bild erzeugt wird. Dieses latente Bild wird durch spezifische Behandlung z.B. eine Silylierung verstärkt. Dazu wird eine zumindest eine Hydroxyl oder Aminogruppe aufweisende organische Metallverbindung in wäßriger oder zumindest Wasser enthaltender Lösung oder Emulsion verwendet. Die Hydrolysestabilität und noch gleichzeitig vorhandene Reaktivität der Komponente B erlaubt eine Behandlung bei Raumtemperatur und Raumatmosphäre, das heißt Normaldruck und Normalatmosphäre. Selbstverständlich kann die Reaktion durch erhöhte Temperatur beschleunigt werden. Die so behandelte Photoresistschicht wird schließlich anisotrop in einem sauerstoffhaltigen Plasma geätzt, wobei die z.B. silylierten Bereiche eine erhöhte Ätzresistenz aufweisen und die darunterliegenden Schichtbereiche vor einem Abtrag im Sauerstoffplasma bewahren. Bedingt durch die hohe Ätzresistenz der spezifisch in den belichteten Bereichen silylierten Photoresistschicht und durch die Anisotropie des Ätzverfahrens weisen die erzeugten Strukturen steile Flanken auf.

Entsprechend des einfach durchzuführenden Verfahrens kann die Behandlung mit dem Silylierungsagens in einfachen Apparaturen durchgeführt werden, die in jeder gängigen Anlage der Halbleiterindustrie bereits vorhanden sind. Erfindungsgemäß können dazu zum Beispiel Sprüh-, Puddle- oder Tauchentwickler verwendet werden.

Durch die Anbindung der Organosiliziumverbindung in den belichteten Bereichen der vormals ebenen Photoresistschicht wird ein Volumenzuwachs der Resistschicht in diesen Bereichen erzielt, der in Form von Erhebungen der Photoresistschicht auch optisch ausgemessen werden kann. Die Reaktionszeit für eine ausreichende bis vollständige Silylierung der Photoresistschicht in den belichteten Bereichen beträgt zwischen 10 Sekunden und 5 Minuten. Durch Veränderung der Reaktionszeit bzw. Verkürzung der Behandlungsdauer kann das Ausmaß der Silylierung und des dadurch bedingten Volumenzuwachs es geregelt werden. Dies ist von umso größerer Bedeutung, je kleiner die Größenordnung der zu erzeugenden Strukturen ist. Eine Struktur im 0,5-µm-Bereich beispielsweise erfordert höchste Genauigkeit bei der Strukturerzeugung. Dazu gehört vor allem, daß die auf der Maske vorgegebenen Strukturen exakt übertragen werden. Jede verfahrensbedingte Veränderung des Maßstabs muß daher vermieden oder ausgeglichen werden. Daher erfordert auch das erfindungsgemäße Verfahren eine genaue Kontrolle der durch den Volumenzuwachs bei der Behandlung bedingten lateralen Strukturverbreiterung. Die Kontrolle bzw. Steuerung der Silylierungsreaktion kann neben der Behandlungsdauer noch durch die Konzentration des Silylierungsagens oder durch die Temperatur erfolgen. Mit längerer Behandlungsdauer, höherer Konzentration oder höherer Temperatur wird ein höherer Umsatz bei der Silylierung erzeugt und durch den höheren Volumenzuwachs eine Verbreiterung der erhabenen Photoresiststrukturen erzielt, welche sich durch ein kleiner werdendes Verhältnis der Durchmesser von Resistgraben/Resiststeg bemerkbar macht.

Die vorteilhaft in flüssiger Phase durchgeführte chemische Behandlung kann auch in der Gasphase durchgeführt werden. Mit Aminosilanen und Aminosiloxanen, entsprechende Flüchtigkeit vorausgesetzt, können so anhydridhaltige Resists behandelt werden. Siloxane als Agens sind auch allgemein bevorzugt, da sie auf dem Resist beim Ätzen im Sauerstoffplasma schneller und vollständiger in nichtflüchtiges $SiO_2$ übergehen. Die Gasphasenreaktion erzeugt allerdings flachere Silylierungsprofile als die Behandlung mit einem Agens in flüssiger Phase, so daß die Folge eine geringere Prozeßsicherheit beim Ätzschritt bezüglich der Maßhaltigkeit der Strukturübertragung ist.

Im folgenden werden für das erfindungsgemäße Resistsystem mehrere geeignete Komponenten 1-6 angegeben und deren Verwendung im erfindungsgemäßen Verfahren anhand von sechs Ausführungsbeispielen und der dazugehörigen sechs Figuren näher erläutert.

Reagenzien:

1. Ein Copolymer aus Styrol und Maleinsäureanhydrid mit dem Molekulargewicht $M_n = 2400$ wird durch radikalische Polymerisation der beiden Monomeren mit Azoisobuttersäuredinitril als Initiator und n-Butylmercaptan als Regler hergestellt.

2. Ein Copolymer aus Styrol und Maleinsäureanhydrid mit dem Molekulargewicht $M_n = 6700$ wird wie unter 1. hergestellt, jedoch ohne Verwendung eines Reglers.

3. Ein Diester des Bisphenol A mit Naphthochinondiazid-4-sulfonsäure wird als photoaktive Komponente (PAC) eingesetzt.

4. Eine Silylierungslösung besteht aus 25 Gewichtsteilen (GT) Diaminosiloxan, 50 GT Isopropylalkohol und 25 GT Wasser. Vorzugsweise wird ein $\alpha$, $\Omega$ -amino-funktionelles Siloxan, zum Beispiel mit zwei endständigen Aminopropylgruppen und 10 bis 12 Siliziumatomen in der Kette verwendet.

5. Eine weitere Silylierungslösung besteht aus 8 GT oligomeres Diaminosiloxan 79 GT Isopropylalkohol, 12,8 GT Wasser und 0,2 GT Ammoniak.

6. Eine dritte Silylierungslösung besteht aus 2 GT Bis -(3-aminopropyl)-tetramethyldisiloxan, 1 GT Emulgator (zum Beispiel Pril) und 97 GT Wasser.

1. Ausführungsbeispiel

Auf einen Siliziumwafer wird eine Resistlösung aufgeschleudert, die aus 13,2 GT Basispolymer (2), 8,8 GT PAC (3) und 78 GT 2-Methoxy-1-propylacetat (= MPA) als Lösungsmittel besteht. Nach Trocknung bei 110°C auf der Hotplate ist eine Resistschicht von 1200 nm Dicke entstanden. Diese wird nun durch eine Maske, welche bis zu 0,5 µm kleine Strukturen aufweist, mit 50 $mJ/cm^2$ mit Licht von 257 nm kontaktbelichtet. Danach wird mit der Silylierungslösung (4) 60 Sekunden behandelt und anschließlich mit Isopropanol gespült. In einem Plasmareaktor wird nun im Sauerstoffplasma ($O_2$/RIE, 6 mTorr Gasdruck und 410 V bias-Spannung) trockenentwickelt. Es werden 0,5 µm breite Strukturen mit senkrechten Flanken erhalten, bei denen das Verhältnis Steg : Graben 1:1 beträgt. Durch Verlängerung der Silylierungszeit kann dieses Verhältnis zugunsten der Stege gezielt erhöht werden.

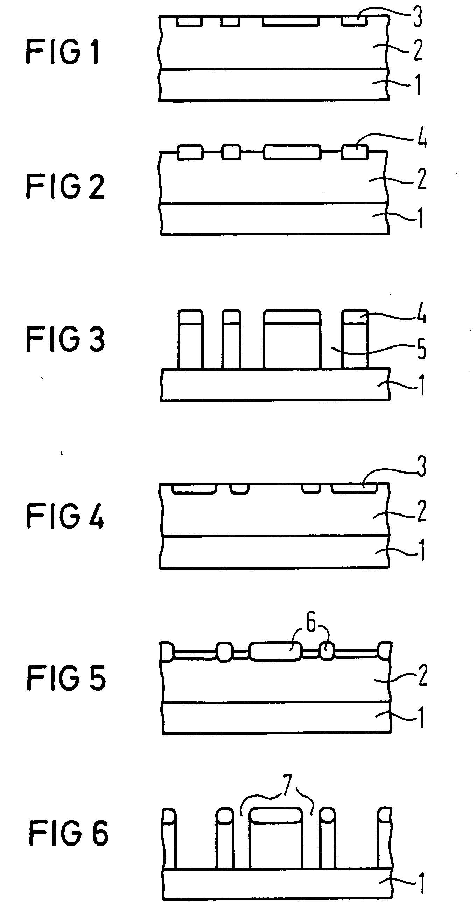

Figur 1 zeigt ein mit einer Photoresistschicht 2 bedecktes Substrat 1 nach der Kontaktbelichtung. Die belichteten Bereiche 2 der Photoresistschicht 2 sind durch die Belichtung chemisch verändert.

Figur 2 zeigt die Anordnung nach der Behandlung mit der Silylierungslösung. Durch spezifische Reaktion dieser Lösung mit dem Photoresist in den belichteten Bereichen 3 haben die so behandelten Bereiche 4 durch chemische Anbindung der Organo-Siliziumverbindung einen Volumenzuwachs erfahren. Das durch die Belichtung zunächst nur latente Bild ist nun auch "optisch" angemessen werden, da die behandelten Bereiche 4 über den unbelichteten Bereichen der Photoresistschicht 2 erhaben sind.

Figur 3 zeigt die Anordnung nach dem Plasmaätzschritt. Durch anisotropes Ätzen sind senkrechte bis auf das Substrat 1 reichende Gräben 5 in der Photoresistschicht 2 entstanden. Die behandelten Bereiche 4 wirken bei dem Plasmaätzschritt als Kontaktmaske und bewahren die darunterliegenden Bereiche der Photoresistschicht 2 vor einem Abtrag im Sauerstoffplasma.

2. Ausführungsbeispiel:

Auf einen Siliziumwafer wird der käufliche Photoresist AZ 1450 J aufgeschleudert und anschließend in zwei Temperaturstufen bis einschließlich 210°C ausgeheizt. Danach beträgt die Schichtdicke des als Planarisierungsschicht dienenden Resists 1,8 µm. Darauf wird nun ein Resist, bestehend aus 12 GT Basispolymer (1), 8 GT PAC (2) und 80 GT MPA aufgeschleudert. Nach dem Trocknen bei 110°C beträgt die Schichtdicke dieser als Topresist dienenden Resistschicht 0,5 µm. Nun wird mit 90 $mJ/cm^2$ bei 257 nm kontaktbelichtet und anschließend 3 bis 5 Sekunden mit der Silylierungslösung behandelt und mit Isopropylalkohol gespült. Auch hier hat die Silylierung nur in den belichteten Bereichen der Photoresistschicht stattgefunden (siehe auch Figuren 1 und 2). Nach einem anschließenden Reaktivionenätzen (bei 500 V und 6 mTorr) werden Strukturen mit senkrechten Flanken und Strukturbreiten bis 0,5 µm erhalten die den kleinsten auf der Maske vorgegebenen Strukturen entsprechen. Beim Ätzen dienen die behandelten Bereiche 4 als Kontaktmaske und verhindern einen Abtrag der darunterliegenden Bereiche der Photoresistschicht 2 und der entsprechenden Bereiche des Bottomresist (in der Figur nicht dargestellt).

3. Ausführungsbeispiel:

Eine Resistlösung, bestehend aus 13 GT Basispolymer (1), 7 GT PAG (3) und 80 GT Cyclohexanon als Lösungsmittel, wird auf einen Siliziumwafer aufgeschleudert und bei 110° getrocknet. Es wird ein Resist von 1,4 µm Schichtdicke erhalten. Dieser wird durch eine Maske mit 40 $mJ/cm^2$ bei 363 nm kontaktbelichtet, anschließend mit der Silylierungslösung (5) 10 Sekunden behandelt und anschließend mit Isopropanol gespült. Die Ätzung erfolgt in einem Plasmareaktor ($O_2$/RIE, 6 mTorr Gasdruck und 410 V bias-Spannung). Es werden Strukturen bis 0,5 µm Strukturbreite mit senkrechten Flanken erhalten (siehe Figur 3).

4. Ausführungsbeispiel:

Wie im Ausführungsbeispiel 3 wird der beschriebene Resist aufgebracht und belichtet. Anschließend wird er 60 Sekunden mit der Silylierungslösung (6) behandelt und danach mit Isopropanol gespült. Nach Trockenätzen (wie im Ausführungsbeispiel 3) werden wiederum gut aufgelöste Strukturen mit senkrechten Flanken erhalten.

5. Ausführungsbeispiel:

Eine Resistlösung, bestehend aus 18 GT eines Epoxynovolaks, 2 GT PAC (3), 0,02 bis 0,04 GT eines photoaktiven starken Säurebildners (zum Beispiel Digacure KI 85) und 80 GT Cyclohexanon, wird auf einen Wafer so aufgebracht, daß nach der Trocknung bei 90°C eine Schichtdicke von 1,4 µm erhalten wird. Durch eine Maske wird mit 30 $mJ/cm^2$ bei 249 nm kontaktbelichtet und anschließend 60 Sekunden mit der Silylierungslösung (4) behandelt. Nach Spülen mit Isopropanol wird im Plasmareaktor ($O_2$/RIE, 6 mTorr Gasdruck und 410 V bias-Spannung) trockenentwickelt. Es werden negative Strukturen (entsprechend den behandelten Bereichen 4 in der Figur 3) mit senkrechten Flanken erhalten. Die Silylierungsreaktion kann durch einen geeigneten Katalysator beschleunigt werden.

6. Ausführungsbeispiel:

In einer Abwandlung des Erfindungsgedankens ist es möglich, durch zwei weitere einfache Verfahrensschritte mit derselben Belichtung ein positives Bild bzw. positive Strukturen zu erhalten. Dazu wird die im Ausführungsbeispiel 5 erzeugte Resistschicht nach der Kontaktbelichtung durch die Maske 120 Sekunden auf 80 bis 90°C erwärmt. Bei diesem Temperschritt kommt es unter Katalyse der durch die Belichtung entstandenen Säure zum Abreagieren der gesamten reaktiven Gruppen in den belichteten Bereichen 3. Nun wird der Resist mit 30 $mJ/cm^2$ (ohne Maske) flutbelichtet und mit der Silylierungslösung (4) 60 Sekunden behandelt. Dabei werden nur diejenigen Bereiche 6 silyliert (siehe Figur 5), die bei der ersten und durch eine Maske durchgeführten Belichtung unbelichtet blieben und erst durch die zweite Flutbelichtung chemisch aktiviert wurden. Nach Spülen mit Isopropanol wird wie im Beispiel 5 trockengeätzt.

Figur 6 zeigt die Anordnung nach diesem Schritt, in der die erhabenen und durch die Bereiche 6 definierten Strukturen einem positiven Bild des ersten Belichtungsschrittes (durch die Maske) entsprechen. Dieses Verfahren gestattet es also, mit wenigen und einfachen Schritten eine Bildumkehr der auf der Maske vorgegebenen Strukturen zu erzeugen.

Ganz allgemein zeichnet sich das erfindungsgemäße Verfahren durch einfache Prozeßführung (Behandlung) bei Raumtemperatur, Raumklima und kurze Prozeßzeit aus. Die Prozesse sind vollständig in bestehende Anlagen integrierbar und erfordern keine neuen Zusatzinvestitionen. Die behandelten Bereiche zeigen eine hohe Ätzresistenz, die eine maßhaltige Strukturübertragung erlaubt. In Vergleichsversuchen wurde festgestellt, daß durch Behandlung mit den erfindungsgemäßen Siloxanen deutlich höhere Sauerstoffätzresistenz erzeugt wird als mit vergleichbaren und aus der Literatur bekannten Silylethern von phenolischen Substanzen, die bei der Durchführung vergleichbarer bekannter Prozesse entstehen. Auch werden die behandelten Resistbereiche erfindungsgemäß mit einem mehrfunktionellen Agens chemisch nernetzt, wodurch sie dimensionsstabiler werden. So wird also eine doppelte Prozeßsicherheit erreicht, indem vorzugsweise bei Raumtemperatur behandelt wird und gleichzeitig durch Vernetzung die Erweichungstemperatur der Resiststrukturen erhöht wird. Ein "Verfließen" der Strukturen bei erhöhten Temperaturen wird so verhindert.

Das erfindungsgemäße Verfahren kann wie auch in den Ausführungsbeispielen aufgezeigt nicht nur für Einlagensysteme, sondern auch für trockenentwickelbare Zweilagensysteme eingesetzt werden. Der reaktive Resist befindet sich dann als dünne Lage auf einer Planarisierungsschicht, die je nach Anforderungen frei wählbar ist. Je nach Auswahl der photoaktiven Komponente, die im Bereich der Belichtungswellenlänge absorbieren und reagieren muß, kann der Resist zum Beispiel bei 248, 313, 365 oder bei 436 nm belichtet werden.

**Patentansprüche**

**1.** Fein strukturierbares Resistsystem für ein Trockenentwicklungsverfahren, bei dem in einer Photoresistschicht durch abbildende Belichtung ein latentes Bild erzeugt und durch chemische Behandlung mit einem Agens eine spezifische chemische Veränderung zur Erhöhung der Ätzresistenz gegenüber einem Trockenätzverfahren erzielt wird,
**gekennzeichnet durch**
Komponente A: einen strukturierbaren Resist auf der Grundlage eines Basispolymeren und eines Chinondiazids als photoaktive Komponente, wobei das Basispolymer reaktive Gruppen enthält, die ausgewählt sind aus Anhydrid, Enolether und Epoxid, Komponente B: als Agens ein Organosilan oder ein Organosiloxan mit zumindest einer Aminofunktion als reaktive Gruppe, wobei das Agens in wäßriger oder zumindest Wasser enthaltender Lösung oder Emulsion vorliegt.

**2.** Resistsystem nach Anspruch 1,
**dadurch gekennzeichnet**,
daß die Komponente B eine $\alpha$, $\Omega$-bifunktionelle Organosiliziumverbindung mit 1 bis 50, vorzugsweise mit 2 bis 12

Siliziumatomen pro Molekül ist.

**3.** Resistsystem nach Anspruch 1 oder 2,
**dadurch gekennzeichnet,**
daß das Polymer der Komponente A von Maleinsäure Anhydrid-Monomeren abgeleitet ist.

**4.** Resistsystem nach Anspruch 3,
**dadurch gekennzeichnet,**
daß die Komponente A ein Copolymer aus Maleinsäureanhydrid und Styrol aufweist.

**5.** Verfahren zum Herstellen einer Resiststruktur mit steilen Flanken, bei dem

- auf einem Substrat eine Photoresistschicht (Komponente A) erzeugt wird auf der Grundlage eines Basispolymeren und eines Chinondiazids als photoaktive Komponente, wobei das Basispolymer reaktive Gruppen enthält, die ausgewählt sind aus Anhydrid, Enolether und Epoxid,

- diese Photoresistschicht bildmäßig belichtet wird, wobei in den belichteten Bereichen eine photochemische Reaktion ausgelöst und so in der Photoresistschicht ein latentes Bild erzeugt wird,

- dieses latente Bild durch spezifische chemische Behandlung mit einem Agens (Komponente B) verstärkt wird, wobei als Agens ein Organosilan oder ein Organosiloxan mit zumindest einer Aminogruppe in flüssiger wäßriger oder zumindest Wasser enthaltender Phase verwendet wird,

- die so behandelte Photoresistschicht schließlich anisotrop in einem sauerstoffhaltigen Plasma geätzt wird, wobei die behandelten Bereiche eine erhöhte Ätzresistenz aufweisen und als erhabene Strukturen mit steilen Ätzflanken verbleiben.

**6.** Verfahren nach Anspruch 5,
**dadurch gekennzeichnet**,
daß die Behandlung in einem üblichen Sprüh-, Puddle- oder Tauchentwickler durchgeführt wird.

**7.** Verfahren nach Anspruch 5,
**dadurch gekennzeichnet,**
daß als Agens ein Diaminosiloxan mit 1 bis 50, vorzugsweise mit 2 bis 12 Siliziumatomen verwendet wird.

**8.** Verfahren nach mindestens einem der Ansprüche 5 bis 7,
**dadurch gekennzeichnet,**
daß die Dauer der Behandlung 10 s bis 5 min beträgt.

**9.** Verfahren nach einem der Ansprüche 5 bis 8,
**dadurch gekennzeichnet,**
daß für die Photoresistschicht eine Mischung eines Basispolymeren und einer photoaktiven Komponente (PAC) verwendet wird.

**10.** Verfahren nach mindestens einem der Ansprüche 5 bis 9,
**dadurch gekennzeichnet,**
daß die Photoresistschicht über einer trockenätzbaren Planarisierungsschicht als Topresist erzeugt wird.

**11.** Verfahren nach einem der Ansprüche 9 oder 10,
**dadurch gekennzeichnet,**
daß die photoaktive Komponente von einer der durch die allgemeinen Strukturformeln P, Q und R beschreibbaren Strukturen abgeleitet ist,

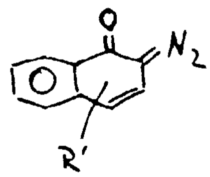

P

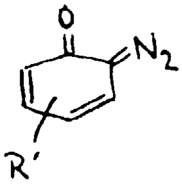

Q

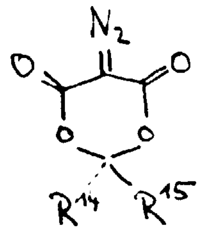

R

wobei R' für $-SO_3R$ oder $-CO_2R$, $R^{15}$ und $R^{14}$ einen beliebigen organischen Rest steht und R für Alkyl, Aryl, Halogenalkyl, Halogenaryl oder Halogen steht.

**12.** Verfahren nach mindestens einem der Ansprüche 5 bis 11,
**dadurch gekennzeichnet,**
daß die belichtete Photoresistschicht vor der chemischen Behandlung zunächst erhitzt wird, um durch chemische Reaktion die aktivierten (belichteten) Bereiche zu desaktivieren, und daß anschließend flutbelichtet wird, um eine Aktivierung der im ersten Schritt nicht belichteten Bereiche zu erzeugen.

## Claims

**1.** Finely structurable resist system for a dry development process, in which a latent image is produced in a photoresist layer by imaging exposure and a specific chemical alteration is achieved by chemical treatment with an agent to increase the etching resistance to a dry-etching process, characterized by component A: a structurable resist based on a basic polymer and a quinone diazide as photoactive component, the basic polymer containing reactive groups which are selected from anhydride, enol ether and epoxide, component B: an organosilane or an organosiloxane as agent and containing at least one amino function as reactive group, the agent being present in aqueous, or at least water-containing, solution or emulsion.

**2.** Resist system according to Claim 1, characterized in that the component B is an $\alpha$, $\Omega$-bifunctional organosilicon compound containing 1 to 50, preferably containing 2 to 12 silicon atoms per molecule.

**3.** Resist system according to Claim 1 or 2, characterized in that the polymer of the component A is derived from maleic anhydride monomers.

**4.** Resist system according to Claim 3, characterized in that the component A comprises a copolymer of maleic anhydride and styrene.

**5.** Process for preparing a resist structure having steep edges, in which

- a photoresist layer (component A) based on a basic polymer and a quinone diazide as photoactive component is produced on a substrate, the basic polymer containing reactive groups which are selected from anhydride, enol ether and epoxide,
- said photoresist layer is imagewise exposed, a photochemical reaction being initiated in the exposed areas and a latent image thus being produced in the photoresist layer,
- said latent image is enhanced by specific chemical treatment with an agent (component B), an organosilane or an organosiloxane containing at least one amino group being used as agent in liquid, aqueous or at least water-containing phase,
- the photoresist layer thus treated is finally etched anisotropically in an oxygen-containing plasma, the treated areas having an increased etching resistance and remaining behind as elevated structures with steep etching edges.

**6.** Process according to Claim 5, characterized in that the treatment is carried out in a conventional spray, puddle or immersion developer.

7. Process according to Claim 5, characterized in that a diaminosiloxane containing 1 to 50, preferably 2 to 12 silicon atoms is used as agent.

8. Process according to at least one of Claims 5 to 7, characterized in that the duration of the treatment is 10 s to 5 min.

9. Process according to one of Claims 5 to 8, characterized in that a mixture of a basic polymer and a photoactive component (PAC) is used for the photoresist layer.

10. Process according to at least one of Claims 5 to 9, characterized in that the photoresist layer is produced as top resist on top of a dry-etchable planarization layer.

11. Process according to one of Claims 9 or 10, characterized in that the photoactive component is derived from one of the structures which can be described by the general structural formulae P, Q and R

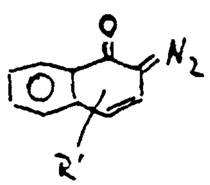

P

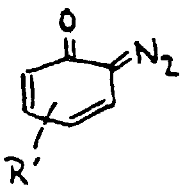

Q

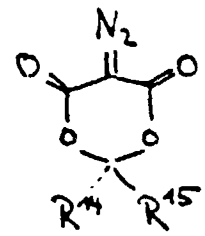

R

where R' is $-SO_3R$ or $-CO_2R$, $R^{15}$ and $R^{14}$ are any organic radical and R is alkyl, aryl, haloalkyl, haloaryl or halogen.

12. Process according to at least one of Claims 5 to 11, characterized in that the exposed photoresist layer is first heated prior to the chemical treatment in order to deactivate the activated (exposed) areas by chemical reaction, and in that flood exposure is then carried out in order to produce an activation of the areas not exposed in the first step.

## Revendications

1. Système formant réserve finement structurable pour un procédé de développement à sec, au cours duquel on réalise dans une couche de photoréserve par exposition de reproduction une image latente et au cours duquel on obtient, par traitement chimique avec un agent chimique, une modification chimique spécifique en vue d'une augmentation de la résistance à la gravure envers un procédé de gravure à sec,
caractérisé par

une composante A : une réserve structurable sur base d'un polymère de base et d'un quinonediazide à titre de composante photoactive, le polymère de base contenant des groupes réactionnels qui sont choisis parmi les anhydrides, les éthers énoliques et les époxydes,
une composante B : à titre d'agent chimique un organosilane ou un organosiloxane avec au moins une fonction amino à titre de groupe réactionnel, l'agent chimique se trouvant sous forme de solution ou d'émulsion aqueuse ou contenant au moins de l'eau.

2. Système formant réserve selon la revendication 1,
caractérisé en ce que
la composante B est un composé d'organosilicium $\alpha,\Omega$-bifonctionnel avec 1 à 50, de préférence avec 2 à 12 atomes de silicium par molécule.

3. Système formant réserve selon la revendication 1 ou 2,
caractérisé en ce que
le polymère de la composante A est dérivé de monomères d'anhydride de l'acide maléique.

**4.** Système formant réserve selon la revendication 3,
caractérisé en ce que
la composante A présente un copolymère constitué d'anhydride de l'acide maléique et de styrène.

**5.** Procédé de fabrication d'une structure de réserve avec des flancs raides, au cours duquel

- on produit sur un substrat une couche de photoréserve (composante A) sur base d'un polymère de base et d'un quinonediazide à titre de composante photoactive, le polymère de base contenant des groupes réactionnels qui sont choisis parmi les anhydrides, les éthers énoliques et les époxydes,
- on expose cette couche de photoréserve par une image, une réaction photochimique étant déclenchée dans les régions exposées et produisant ainsi une image latente dans la couche de photoréserve,
- cette image latente est amplifiée par un traitement chimique spécifique avec un agent chimique (composante B), en utilisant à titre d'agent chimique un organosilane ou un organosiloxane avec au moins un groupe amino en phase liquide aqueuse ou contenant au moins de l'eau,
- la couche de photoréserve ainsi traitée est finalement gravée de manière anisotrope dans un plasma contenant de l'oxygène, les régions traitées présentant une résistance plus élevée à la gravure et subsistant sous forme de structures en relief avec des flancs de gravure raides.

**6.** Procédé selon la revendication 5,
caractérisé en ce que
le traitement est effectué dans un appareil courant de développement par aspersion, de type Puddle ou par immersion.

**7.** Procédé selon la revendication 5,
caractérisé en ce que
on utilise à titre d'agent chimique un diaminosiloxane avec 1 à 50, de préférence avec 2 à 12 atomes de silicium.

**8.** Procédé selon au moins une des revendications 5 à 7,
caractérisé en ce que
la durée du traitement est de 10 s à 5 min.

**9.** Procédé selon une des revendications 5 à 8,
caractérisé en ce que
on utilise pour la couche de photoréserve une composition d'un polymère de base et d'une composante photoactive (PAC).

**10.** Procédé selon au moins une des revendications 5 à 9,
caractérisé en ce que
la couche de photoréserve est produite à titre de topréserve au-dessus d'une couche d'aplanissement pouvant être gravée à sec.

**11.** Procédé selon une des revendications 9 ou 10,
caractérisé en ce que
la composante photoactive est dérivée d'une des structures pouvant être décrites par les formules de structure générales P, Q et R,

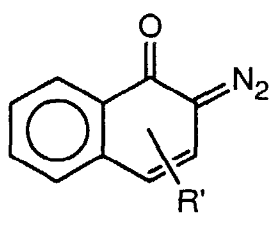
P

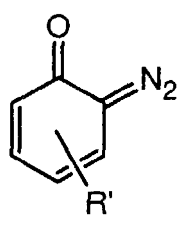
Q

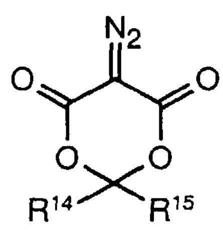
R

où R' représente $-SO_3R$ ou $-CO_2R$, $R^{15}$ et $R^{14}$ représentent un résidu organique quelconque, et R représente un

groupe alkyle, un groupe aryle, un groupe halogénoalkyle, un groupe halogénoaryle ou un atome d'halogène.

**12.** Procédé selon au moins une des revendications 5 à 11,
caractérisé en ce que
la couche de photoréserve exposée est d'abord chauffée avant le traitement chimique pour désactiver par réaction chimique les régions activées (exposées), et en ce qu'on éclaire ensuite par projecteurs pour effectuer une activation des régions non-exposées à la première étape.

FIG 1

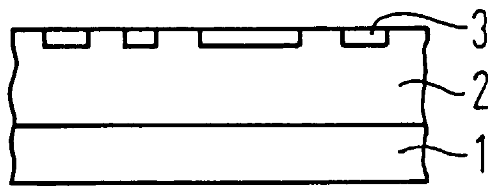


FIG 2

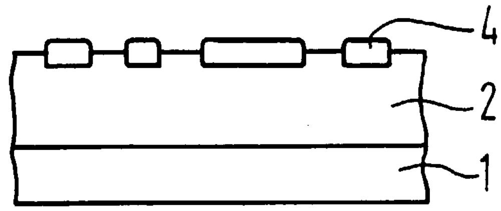


FIG 3

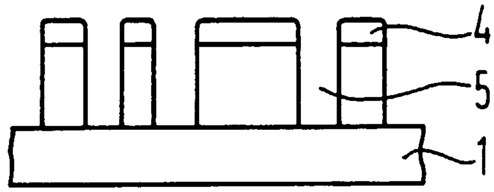


FIG 4

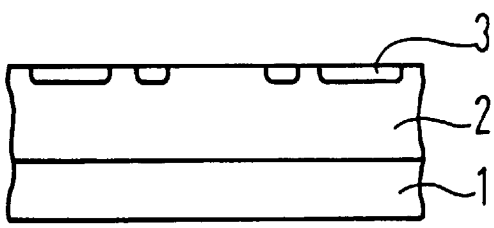


FIG 5

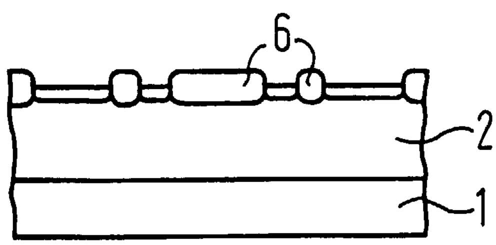


FIG 6